# EUROPEAN PATENT APPLICATION

(11) **EP 2 852 271 A1**
(43) Date of publication of application: **25.03.2015**
(21) Application number: 14185058.6
(22) Date of filing: 17.09.2014
(51) Int. Cl.: H05K 13/04, H01L 21/67

(54) **Contact apparatus**

(30) Priority: 23.09.2013 JP 2013196306
(71) Applicant: Nidec-Read Corporation, Ukyo-ku Kyoto-shi Kyoto 615-0854 (JP)
(72) Inventor: Nakagawa, Takashi, Kyoto, 615-0854 (JP); Matsukawa, Toshihide, Kyoto, 615-0854 (JP)
(74) Representative: Viering, Jentschura & Partner Patent- und Rechtsanwälte

(57) **Abstract**

A contact head unit (11) provided in a contact apparatus (1) is provided with a contact rod (21), a housing (22), a thrust air passage (32), and a cancel air passage (33). The housing (22) supports the contact rod (21) linearly movably by a static pressure air bearing, which allows the contact rod (21) to be brought into contact with an object (3). If a compressed air is supplied to the thrust air passage (32), a force in a direction of approaching the object (3) acts on the contact rod (21). If the compressed air is supplied to the cancel air passage (33), a force in an opposite direction acts on the contact rod (21). A control unit (12) sets applied pressure on the object (3) by controlling the pressure of the compressed air of the thrust air passage (32) and the pressure of the compressed air of the cancel air passage (33) while the contact rod (21) is in contact with the object (3).

## Description

### BACKGROUND OF THE INVENTION

### 1. Field of the Invention

The present invention relates to a contact apparatus configured to bring a movable member into contact with an object.

### 2. Description of the Related Art

There is conventionally known a contact apparatus having a movable member and configured to bring the movable member (or another member attached to the movable member) into contact with an object. Patent document 1 discloses a bonding head used for a bonding apparatus, as one example of the contact apparatus as descried above.

The bonding head in the Patent document 1 has a bonding tool (or movable member) configured to suck and hold on a tip an electronic component such as a semiconductor chip, and to press the electronic component to a substrate (or object). As a pressure device of the bonding tool, there are two separate devices, i.e. a first pressure device configured to perform low load pressurization control and a second pressure device configured to perform high load pressurization control. The first pressure device can be moved by being disposed in a head moving device of the bonding head, while the second pressure device is a fixed device separated from the bonding head. The Patent document 1 describes that both high load pressurization (20 to 30 kgf) and low load pressurization (2 to 3 kgf) can be accurately performed thanks to this configuration.

Patent document 1: Japanese Patent Application Laid-Open No. 2009-27105

By the way, for example, in a circumstance in which an extremely delicate component is handled, or in similar circumstances, it is desired in some cases that applied pressure between the movable member and the object is zero even though they are in contact with each other. In this regard, the bonding head in the Patent document 1 aims at pressurizing the electronic component with sufficient power to the substrate for the bonding, and the zero load as described above thus cannot be considered at all.

### SUMMARY OF THE INVENTION

In view of the aforementioned circumstances, it is therefore an object of the present invention to provide a contact apparatus which can realize the state in which the applied pressure is zero while the movable member (or another member attached to the movable member) and the object are in contact.

The problem to be solved by the present invention is as described above, and means for solving the problem and an effect thereof will be explained next.

According to the subject of the present invention, a contact apparatus in the following configuration is provided. In other words, the contact apparatus is provided with: a contact head unit; and a control unit. The contact head unit is provided with: a movable member; a housing; a bearing gas passage; a thrust gas passage; and a cancel gas passage. The movable member can be in contact with an object. The housing forms a storage chamber for accommodating the movable member and supports the movable member linearly movably. The bearing gas passage is a passage for a compressed gas supplied to form a static pressure gas bearing between the housing and the movable member. The thrust gas passage is a passage for the compressed gas supplied to make a force act on the movable member, wherein the force is in a direction of bringing the movable member close to the object. The cancel gas passage is a passage for the compressed gas supplied to make a force act on the movable member, wherein the force is in a direction of putting the movable member away from the object. All of the bearing gas passage, the thrust gas passage, and the cancel gas passage are opened to the storage chamber of the housing. The control unit can set applied pressure of the movable member on the object to be zero by controlling at least any of pressure of the compressed gas supplied to the thrust gas passage and pressure of the compressed gas supplied to the cancel gas passage while the movable member is in contact with the object.

Incidentally, the expression "the movable member is in contact with the object" in the present invention includes not only a case where the movable member is in direct contact with the object, but also a case where a member attached to the movable member or a member held by the movable member is in contact with the object.

This configuration makes it possible to create the state in which the contact member (or the movable member) is in contact with the object at an applied pressure of zero, and a mechanical load applied to the object can be thus substantially eliminated. As a result, an appropriate contact state can be created even if the object is extremely delicate.

The contact apparatus described above preferably has the following configuration. The contact apparatus is provided with a setting unit configured to set the applied pressure of the movable member on the object in a predetermined range. Zero is included in the range of the applied pressure which can be set by the setting unit.

This makes it possible to set the applied pressure in a wide range including zero. It is thus possible to provide the contact apparatus which can be used in various applications.

The contact apparatus described above preferably has the following configuration. The contact apparatus is provided with a load sensor configured to detect a load of the movable member. The control unit controls at least any of the pressure of the compressed gas supplied to the thrust gas passage and the pressure of the compressed gas supplied to the cancel gas passage, on the basis of a detection value of the load sensor.

This allows feedback control while confirming the magnitude of the actual applied pressure. It is thus possible to easily realize a state in which the applied pressure is strictly zero.

### BRIEF DESCRIPTION OF THE DRAWINGS

FIG. 1 is a conceptual diagram and a block diagram illustrating an entire configuration of a contact apparatus in an embodiment of the present invention; and
FIG. 2 is a conceptual diagram and a block diagram illustrating a modified example of the contact apparatus.

### DETAILED DESCRIPTION OF THE PREFERRED EMBODIMENT

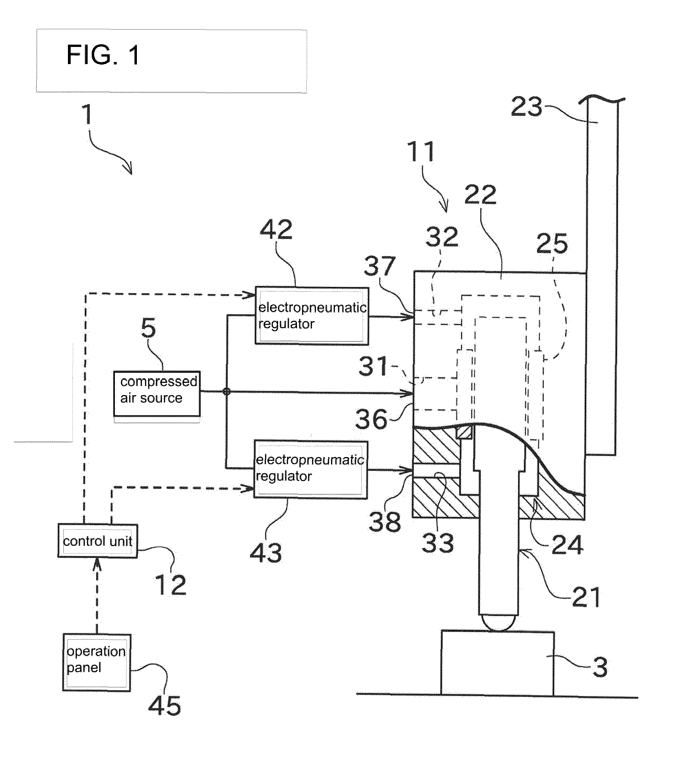

Next, an embodiment of the present invention will be explained with reference to the drawings. FIG. 1 is a conceptual diagram and a block diagram illustrating an entire configuration of a contact apparatus 1 in the embodiment of the present invention

The contact apparatus 1 illustrated in FIG. 1 is an apparatus configured to bring a contact rod 21 into contact with an object 3, for example, for the purpose of inspection or the like. The contact apparatus 1 is provided with a contact head unit 11 and a control unit 12.

The contact head unit 11 is provided with the contact rod (or movable member, or needle, or contact member) 21 and a housing 22 configured to accommodate the contact rod 21 therein. The contact head unit 11 is configured as a static pressure air bearing actuator (or gas bearing actuator), and can support the contact rod 21 by an air bearing (or gas bearing) in a noncontact manner. The housing 22 is coupled via a coupling frame 23 which is a coupling member, to a not-illustrated driving apparatus which is provided with an electric motor, a feed screw mechanism, and the like. The driving apparatus can vertically displace the entire contact head unit 11.

Inside the housing 22, there is formed a rod storage chamber (or storage chamber) 24 configured to accommodate the contact rod 21 therein. The contact rod 21 is formed in a vertically long and narrow round-bar shape. An upper part of the contact rod 21 is inserted in the rod storage chamber 24, and a lower part projects from the housing 22. The contact rod 21 is supported with respect to the housing 22, to be vertically displaced. By displacing the contact rod 21 downward in this configuration, the lower end of the contact rod 21 can be brought into contact with the object 3 set on the apparatus (FIG. 1 illustrates the contact state).

In the rod storage chamber 24, there is provided a cylindrical bush 25 formed of a porous material, and the bush 25 is disposed such that the contact rod 21 is inserted inside the bush 25. Between the bush 25 and the contact rod 21, there is formed a small gap in a radial direction. Moreover, a bearing air passage (or bearing gas passage) 31 is formed in the housing 22. It is configured such that a compressed air (or compressed gas) supplied to the bearing air passage 31 passes through micropores formed in the bush 25, which is formed of the porous material, and such that the compressed air uniformly jets into the gap between the bush 25 and the contact rod 21. The contact rod 21 is held in the noncontact manner by the air bearing formed in this manner, and as a result, sliding resistance when the contact rod 21 vertically moves with respect to the housing 22 can be made small enough to be ignored.

One end of the bearing air passage 31 forms an opening in the rod storage chamber 24, and the other end forms an opening (or bearing port 36) on an outer surface of the housing 22. The bearing port 36 is connected to a compressed air source (or source of supply of a compressed air) 5, through appropriate piping.

In the housing 22 of the contact head unit 11, there is formed a thrust air passage (or thrust gas passage) 32. One end of the thrust air passage 32 forms an opening in the rod storage chamber 24, and the other end forms an opening (or thrust port 37) on the outer surface of the housing 22. The thrust port 37 is connected to an electropneumatic regulator 42 configured to adjust the pressure of the compressed air supplied from the compressed air supply 5, through appropriate piping.

Moreover, in the housing 22 of the contact head unit 11, there is formed a cancel air passage (or cancel gas passage) 33. One end of the cancel air passage 33 forms an opening in the rod storage chamber 24, and the other end forms an opening (or cancel port 38) on the outer surface of the housing 22. The cancel port 38 is connected to an electropneumatic regulator 43 configured to adjust the pressure of the compressed air supplied from the compressed air supply 5, through appropriate piping.

This is not illustrated, but in the housing 22, there is also formed an exhaust passage for letting out the compressed air supplied to the bearing air passage 31, the thrust air passage 32, and the cancel air passage 33, as occasion demands.

Each of the two electropneumatic regulators 42 and 43 is electrically connected to the control unit 12 for controlling the operation of the contact apparatus 1. The control unit 12 is configured as a microcomputer, and is provided with a central processing unit (CPU) as an arithmetic device, and a read only memory (ROM) and a random access memory (RAM) as a storage device, or the like, which are not illustrated.

The electropneumatic regulator 42 adjusts the pressure of the compressed air supplied to the thrust port 37 to pressure according to an electrical signal from the control unit 12. In the same manner, the electropneumatic regulator 43 adjusts the pressure of the compressed air supplied to the cancel port 38 to pressure according to an electrical signal from the control unit 12. This allows the contact rod 21 to linearly move in a direction of approaching / leaving the object 3. Moreover, the details will be described later, but the applied pressure of the contact rod 21 on the object 3 can be changed by the control of the pressure.

The used two electropneumatic regulators 42 and 43 are high-resolution. By this, each of the pressure of the thrust port 37 and the pressure of the cancel port 38 can be fully controlled.

An operation panel (or setting unit) 45 for setting the operation of the contact apparatus 1 is electrically connected to the control unit 12. The operation panel 45 is provided with an appropriate operating device (e.g. keys, a dial, a touch panel, etc.), and a user can set various parameters when operating the contact apparatus 1 by operating the operating device. The set parameters are stored in the storage device provided in the control unit 12.

One of the parameters which can be set by the user with the operation panel 45 is the magnitude of the applied pressure of the contact rod 21 pressurizing the object 3. In other words, by operating the operation panel 45, the user can input and set the magnitude of a force with which the contract rod 21 is pressed to the object 3, in a predetermined range.

On the contact apparatus 1 in the embodiment, zero is included in the range of the applied pressure which can be set by the user. A specific range of the applied pressure has, for example, a lower limit of 0 gf and an upper limit of 3 kgf. If 0 kgf is set as the applied pressure, the control unit 12 controls the two electropneumatic regulators 42 and 43 such that a force with which the contract rod 21 is pressed downward by the compressed air supplied to the thrust port 37, the weight of the contact rod 21 and a force with which the contact rod 21 is pressed upward by the compressed air supplied to the cancel port 38 are in balance.

The contact rod 21 is configured by using a light material, and the sliding resistance is substantially zero due to the air bearing described above. The weight of the contact rod 21 can be cancelled by the supply of the compressed air to the cancel port 38. Moreover, the applied pressure generated on the contact rod 21 is so-called differentially controlled by the pressure supplied to the thrust port 37 and the cancel port 38, and the used electropneumatic regulators 42 and 43 for controlling the pressure are high-resolution. By this, the control unit 12 can realize a state in which the contact rod 21 is in contact with the object 3 but is substantially not pressed to the object 3.

The state of the contact at an applied pressure of zero can be expressed as "extremely soft touch", and can be used in various scenes which cannot be considered before. As one example, the configuration of the contact apparatus 1 in the embodiment is extremely useful in a case where the application of a mechanical load to the object 3 changes characteristics during characteristic inspection in which a probe or the like is in contact with the object 3. The control apparatus 1 in the embodiment can also satisfy the needs of performing electrification inspection or conduction inspection on a component made of an extremely delicate material, without a problem.

As explained above, the contact apparatus 1 in the embodiment is provided with the contact head unit 11 and the control unit 12. The contact head unit 11 is provided with the contact rod 21, the housing 22, the bearing air passage 31, the thrust air passage 32, and the cancel air passage 33. The contact rod 21 can be in contact with the object 3. The housing 22 forms the rod storage chamber 24 for accommodating the contact rod 21 therein and supports the contact rod 21 linearly movably. The bearing air passage 31 is a passage for the compressed air supplied to form the static pressure air bearing actuator between the housing 22 and the contact rod 21. The thrust air passage 32 is a passage for the compressed air supplied to make a force act on the contact rod 21, wherein the force is in a direction of bringing the contact rod 21 close to the object 3. The cancel air passage 33 is a passage for the compressed air supplied to make a force act on the contact rod 21, wherein the force is in a direction of putting the object rod 21 away from the object 3. All of the bearing air passage 31, the thrust air passage 32, and the cancel air passage 33 are opened to the rod storage chamber 24 of the housing 22. The control unit 12 can set the applied pressure on the object 3 to be zero by controlling the pressure of the compressed air supplied to the thrust air passage 32 and the pressure of the compressed air supplied to the cancel air passage 33 while the contact rod 21 is in contact with the object 3.

This makes it possible to create the state in which the contact rod 21 is in contact with the object 3 at an applied pressure of zero, and the mechanical load applied to the object 3 can be thus substantially eliminated. As a result, an appropriate contact state can be created even if the object 3 is extremely delicate.

Moreover, the contact apparatus 1 in the embodiment is provided with the operation panel 45 configured to set the applied pressure of the contact rod 21 on the object 3 in the predetermined range. The range of the applied pressure which can be set with the operation panel 45 includes zero.

This makes it possible to set the applied pressure in a wide range including zero. It is thus possible to provide the contact apparatus 1 which can be used in various applications.

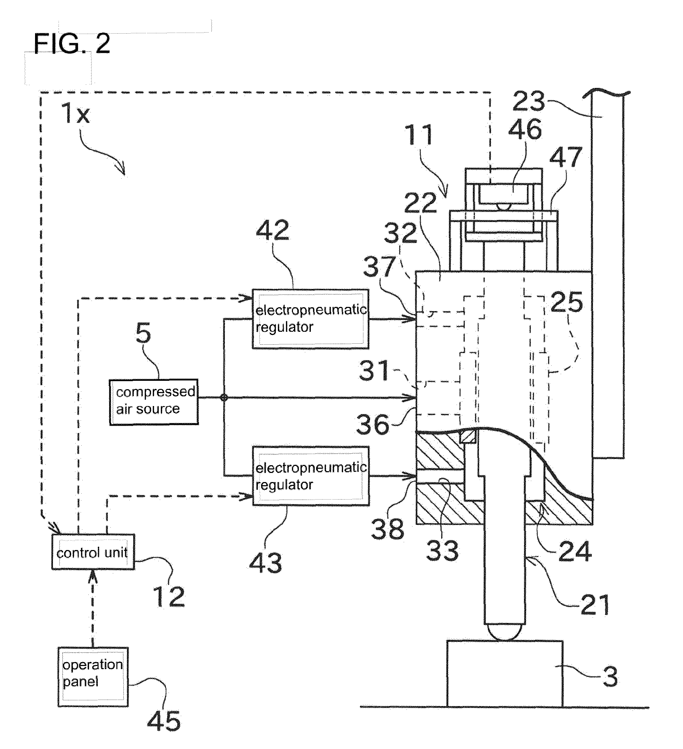

Next, a modified example of the embodiment will be explained. Fig. 2 is a conceptual diagram and a block diagram illustrating a contact apparatus 1x in the modified example. In the explanation of the modified example, the same members as or similar members to those of the aforementioned embodiment will carry the same reference numerals in the drawing, and the explanation will be omitted in some cases.

In the contact apparatus 1x in the modified example, an upper end of the contact rod 21 projects from the housing 22, and a load cell 46 as a load sensor is attached to a tip of the upper end. A piece 47 to be detected is fixed in an upper part of the housing 22, and the load cell 46 is in contact with the piece 47 to be detected. The load cell 46 is electrically connected to the control unit 12.

In the above configuration, the control unit 12 controls the pressure supplied to the thrust port 37 and the cancel port 38, on the basis of the magnitude of a load detected by the load cell 46. This realizes fully-closed feedback control, and it is thus possible to realize the state in which the applied pressure is zero, more accurately.

As exemplified above, the control apparatus 1 in the modified example is provided with the load cell 46 configured to detect the load of the contact rod 21. The control unit 12 controls the pressure of the compressed air supplied to the thrust air passage 32 and the pressure of the compressed air supplied to the cancel air passage 33, on the basis of a detection value of the load cell 46.

This allows the feedback control of the pressure while actually confirming the magnitude of the applied pressure of the contact rod 21. It is thus possible to easily realize the state in which the applied pressure is strictly zero.

The preferred embodiment and the modified example of the present invention are explained above; however, the aforementioned configuration can be changed, for example, as follows.

Instead of the aforementioned embodiment in which the contact rod 21 is brought into contact with the object 3, it may be configured such that another member such as, for example, an inspection probe is fixed to or another component is held by the contact rod 21, and the member / component is brought into contact with the object 3.

In the aforementioned embodiment, in order to realize the applied pressure of zero, the control unit 12 controls both the pressure of the thrust air passage 32 and the pressure of the cancel air passage 33. Instead of this, however, one of the pressures may be kept constant and only the other pressure may be controlled, to realize the applied pressure of zero.

The configuration of the contact head unit 11 is not limited to the aforementioned example. For example, not a simple member but a combination of a plurality of members may be used to form the contact rod and the housing. Moreover, as a pressure medium of the actuator, a gas other than the air may be also used.

### Description of Reference Numerals and Letters

- 1: contact apparatus
- 3: object
- 5: compressed air source
- 11: contact head unit
- 12: control unit
- 21: contact rod (or movable member)
- 22: housing
- 31: bearing air passage (or bearing gas passage)
- 32: thrust air passage (or thrust gas passage)
- 33: cancel air passage (or cancel gas passage)
- 42: electropneumatic regulator
- 43: electropneumatic regulator
- 45: operation panel (or setting unit)
- 46: load cell (or load sensor)

## Claims

1. A contact apparatus (1) comprising:
a contact head unit (11); and
a control unit (12),
the contact head unit (11) comprising:
a movable member (21) configured to be in contact with an object (3);
a housing (22) configured to form a storage chamber for accommodating the movable member (21) and support the movable member (21) linearly movably;
a bearing gas passage (31) which is a passage for a compressed gas supplied to form a static pressure gas bearing between the housing (22) and the movable member (21);
a thrust gas passage (32) which is a passage for the compressed gas supplied to make a force act on the movable member (21), the force being in a direction of bringing the movable member (21) close to the object (3); and
a cancel gas passage (33) which is a passage for the compressed gas supplied to make a force act on the movable member (21), the force being in a direction of putting the movable member (21) away from the object (3), wherein
all of the bearing gas passage (31), the thrust gas passage (32), and the cancel gas passage (33) are opened to the storage chamber of the housing (22), and
the control unit (12) can set applied pressure of the movable member (21) on the object (3) to be zero by controlling at least any of pressure of the compressed gas supplied to the thrust gas passage (32) and pressure of the compressed gas supplied to the cancel gas passage (33) while the movable member (21) is in contact with the object (3).

2. The contact apparatus (1) according to claim 1, wherein
the contact apparatus (1) comprises a setting unit (45) configured to set the applied pressure of the movable member (21) on the object (3) in a predetermined range, and
zero is included in the range of the applied pressure which can be set by the setting unit (45).

3. The contact apparatus according (1) to claim 1 or 2, wherein
the contact apparatus (1) comprises a load sensor (46) configured to detect a load of the movable member (21), and
the control unit (12) controls at least any of the pressure of the compressed gas supplied to the thrust gas passage (32) and the pressure of the compressed gas supplied to the cancel gas passage (33), on the basis of a detection value of the load sensor (46).
